# EUROPEAN PATENT APPLICATION

(11) **EP 3 349 255 A1**
(43) Date of publication of application: **18.07.2018**
(21) Application number: 16844625.0
(22) Date of filing: 01.09.2016
(51) Int. Cl.: H01L 31/0445, H01L 31/0224, H01L 31/04, H01L 31/18

(54) **THIN FILM-TYPE SOLAR CELL AND METHOD FOR MANUFACTURING SAME**

(30) Priority: 09.09.2015 KR 20150127719
(71) Applicant: Moohan Co., Ltd., Gwangju-si, Gyeonggi-do 12773 (KR)
(72) Inventor: KIM, Heon Do, Gwangju-si Gyeonggi-do 12773 (KR)
(74) Representative: AWA Sweden AB
(86) International application number: PCT/KR2016/009750
(87) International publication number: WO 2017/043805

(57) **Abstract**

The present invention provides a thin film type solar cell and a method of manufacturing the same, the thin film type solar cell including: a substrate; a first transparent electrode provided on the substrate, a first separation part being formed in the first transparent electrode; a semiconductor layer formed on the first separation part and the first transparent electrode; a contact part formed to pass through the first transparent electrode and the semiconductor layer; a second transparent electrode formed in the contact part and on the semiconductor layer; and a second separation part formed to pass the semiconductor layer and the second transparent electrode, wherein a size of a grain of the contact part is smaller than a size of a grain of the first transparent electrode.

## Description

### [Technical Field]

The present invention relates to a thin film type solar cell, and more particularly, to a see-through thin film type solar cell.

### [Background Art]

Solar cells are devices that convert light energy into electrical energy, based on the characteristic of a semiconductor.

The solar cells have a P-N junction structure where a positive (P)-type semiconductor and a negative (N)-type semiconductor are joined to each other. When sunlight is incident on a solar cell, a hole (+) and an electron (-) are generated in a semiconductor by energy of the incident sunlight. At this time, due to an electric field which is generated in a P-N junction, the hole (+) moves to a side opposite to a P-type semiconductor, and the electron (-) moves to an N-type semiconductor, thereby generating an electric potential. The solar cell generates power, based on the electric potential.

The solar cells are categorized into thin film type solar cells and wafer type solar cells.

The thin film type solar cells are solar cells which are manufactured by forming a semiconductor on a substrate such as glass in a thin film type, and the wafer type solar cells are solar cells which are manufactured by using a silicon wafer itself as a substrate.

The wafer type solar cells are rather better in efficiency than the thin film type solar cells. However, in the wafer type solar cells, there is a limitation in minimizing a thickness in a manufacturing process, and since a high-cost semiconductor substrate is used, the manufacturing cost increases.

In the thin film type solar cells, it is possible to secure a see-through light transmission area. Therefore, the thin film type solar cells are easily applied to windows of buildings, sunroofs of vehicles, etc.

Hereinafter, a related art see-through thin film type solar cell will be described with reference to the drawings.

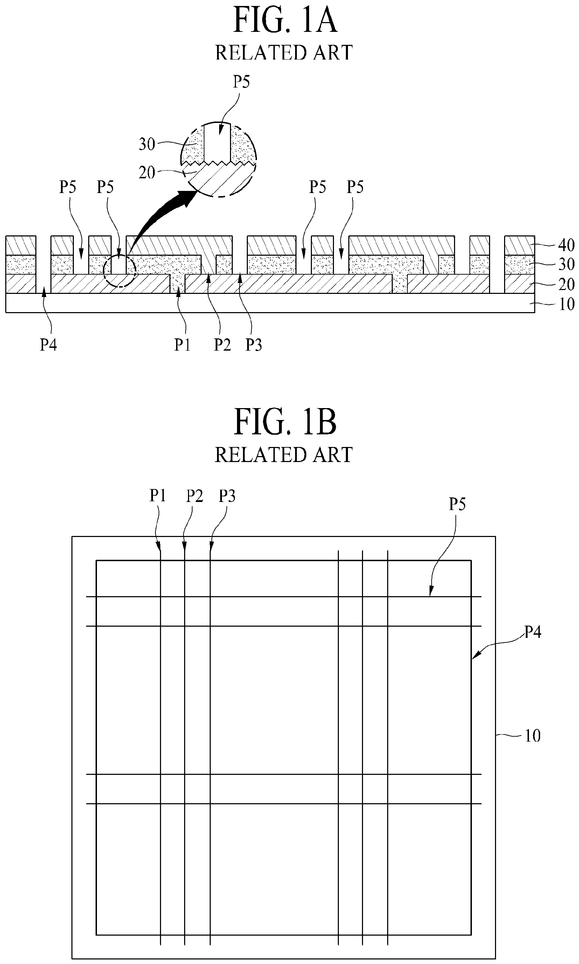

FIG. 1A is a schematic cross-sectional view of a related art thin film type solar cell, and FIG. 1B is a schematic plan view of the related art thin film type solar cell.

As seen in FIG. 1A, the related art thin film type solar cell includes a substrate 10, a first electrode 20, a semiconductor layer 30, and a second electrode 40.

The first electrode 20 is provided on the substrate 10. The first electrode 20 is provided in plurality, and the plurality of first electrodes 20 are spaced apart from each other with a first separation part P1 therebetween.

The semiconductor layer 30 is provided on the first electrode 20. The semiconductor layer 30 is provided in plurality, and the plurality of semiconductor layers 30 are spaced apart from each other with a contact part P2 and a second separation part P3 therebetween.

The second electrode 40 is provided on the semiconductor layer 30 and is provided in plurality. Each of the second electrodes 40 is connected to a corresponding first electrode 20 through the contact part P2, and the plurality of second electrodes 40 are spaced apart from each other with the second separation part P3 therebetween.

A plurality of unit cells may be serially connected to each other by the first separation part P1, the contact part P2, and the second separation part P3.

The third separation part P4 is formed in an outer portion of the substrate 10. The third separation part P4 is provided by removing a certain region of each of the first electrode 20, the semiconductor layer 30, and the second electrode 40. An outer portion of the substrate 10 is insulated through the third separation part P4, and thus, when connecting a housing to a thin-film solar cell in a process of modularizing a finished thin-film solar cell, short circuit can be prevented from occurring between the housing and the thin-film solar cell.

Moreover, a light transmission part P5 is formed in each of the unit cells. The light transmission part P5 is provided by removing a certain region of each of the semiconductor layer 30 and the second electrode 40. A see-through area may be secured by the light transmission part P5.

To describe a planar structure of the related art thin film type solar cell with reference to FIG. 1B, the first separation part P1, the contact part P2, and the second separation part P3 are repeatedly arranged on the substrate 10. The plurality of unit cells may be divided by a repetition unit by which the first separation part P1, the contact part P2, and the second separation part P3 are repeated.

The third separation part P4 is formed in an outer portion of the substrate 10. An outermost area of the substrate 10 is insulated by the third separation part P4. The third separation part P4 is provided in a shape corresponding to a shape of the substrate 10.

Moreover, the light transmission part P5 is formed on the substrate 10, for securing a see-through area. The light transmission part P5 is arranged in a direction intersecting the first separation part P1, the contact part P2, and the second separation part P3.

The related art thin film type solar cell described above has the following drawbacks.

First, in the related art thin film type solar cell, it is required to perform a laser scribing process a total of five times, for forming the first separation part P1, the contact part P2, the second separation part P3, the third separation part P4, and the light transmission part P5. For this reason, a process becomes complicated, and the manufacturing cost increases.

Second, in the related art thin film type solar cell, the see-through area may be secured through the light transmission part P5, but due to a structural limitation of the light transmission part P5, visibility is reduced. To provide a detailed description, as seen in an enlarged view of FIG. 1A, the first electrode 20 is formed in the light transmission part P5, and a surface of the first electrode 20 is formed in a concave-convex structure, for enhancing cell efficiency by improving a light path. For this reason, light passing through the first electrode 20 is refracted or scattered, causing a reduction in visibility.

### [Disclosure]

### [Technical Problem]

The present invention has been made for solving the above-described problems of the related art thin film type solar cell, and it is an object of the present invention to provide a thin film type solar cell and a method of manufacturing the same, in which by simplifying a process, the manufacturing process is reduced, and visibility of a light transmission part is enhanced.

### [Technical Solution]

To accomplish the objects, the present invention provides a thin film type solar cell including: a substrate; a first transparent electrode provided on the substrate, the first transparent electrode having a first separation part; a semiconductor layer formed in the first separation part and on the first transparent electrode; a contact part formed to pass through the first transparent electrode and the semiconductor layer; a second transparent electrode formed in the contact part and on the semiconductor layer; and a second separation part formed to pass through the semiconductor layer and the second transparent electrode, wherein a size of a grain of the contact part is smaller than a size of a grain of the first transparent electrode.

Moreover, the present invention provides a thin film type solar cell comprising a first transparent electrode, a semiconductor layer, and a second transparent electrode sequentially formed on a substrate, wherein the second transparent electrode contacts the substrate by passing through the semiconductor layer and the first transparent electrode, and a size of a grain of the second transparent electrode is smaller than a size of a grain of the first transparent electrode.

Moreover, the present invention provides a thin film type solar cell comprisng a first transparent electrode, a semiconductor layer, and a second transparent electrode sequentially formed on a substrate, wherein the second transparent electrode contacts the substrate by passing through the semiconductor layer and the first transparent electrode, and a reflectivity of the first transparent electrode is higher than a reflectivity of the second transparent electrode.

Moreover, the present invention provides a thin film type solar cell comprising a first transparent electrode, a semiconductor layer, and a second transparent electrode sequentially formed on a substrate, wherein the second transparent electrode contacts the substrate by passing through the semiconductor layer and the first transparent electrode, and an oxygen concentration of the second transparent electrode is higher than an oxygen concentration of the first transparent electrode.

The second transparent electrode may contact a side surface of the first transparent electrode.

The second transparent electrode may contact a top of the substrate, in the contact part.

A width of the contact part may be wider than a width of the first separation part and a width of the second separation part.

Moreover, the present invention provides a thin film type solar cell comprising a front electrode, a semiconductor layer, and a rear electrode that are formed on a substrate, wherein the front electrode includes a first area having a first grain size and a second area having a second grain size smaller than the first grain size, and the second area is connected to the rear electrode.

The second area and the rear electrode may be formed of the same transparent conductive material and are formed as one body.

Moreover, the present invention provides a method of manufacturing a thin film type solar cell including: a process of forming a first transparent electrode layer on a substrate; a process of removing a certain region of the first transparent electrode layer to form a first separation part, thereby forming a plurality of first transparent electrodes which are spaced apart from each other with the first separation part therebetween; a process of forming a semiconductor layer on the first transparent electrode; a process of removing a certain region of each of the semiconductor layer and the first transparent electrode to form a contact part, thereby forming a plurality of semiconductor layers which are spaced apart from each other with the contact part therebetween; a process of forming a second transparent electrode layer on the semiconductor layer; and a process of removing a certain region of each of the semiconductor layer and the second transparent electrode layer to form a second separation part, thereby forming a plurality of second transparent electrodes which are connected to the first transparent electrode through the contact part and are spaced apart from each other with the second separation part therebetween.

The second transparent electrode may contact a side surface of the first transparent electrode and a top of the substrate, in the contact part.

A width of the contact part may be wider than a width of the first separation part and a width of the second separation part.

### [Advantageous Effect]

According to the present invention described above, the following effects are obtained. According to an embodiment of the present invention, a contact part may act as a light transmission area, and thus, unlike the related art, it is not required to form the light transmission area through separate laser scribing. Accordingly, only a total four-time laser scribing process is needed for forming a first separation part, a contact part, a second separation part, and a third separation part, and thus, in comparison with the related art, a one-time laser scribing process is reduced, thereby decreasing the manufacturing cost.

Moreover, in the related art, since a first electrode having a concave-convex structure is formed in the light transmission part, visibility of the light transmission part is reduced. However, according to an embodiment of the present invention, since the first electrode having the concave-convex structure is not formed in a contact part area, visibility of the contact part acting as a light transmission area can be enhanced.

### [Description of Drawings]

FIG. 1A is a schematic cross-sectional view of a related art thin film type solar cell, and FIG. 1B is a schematic plan view of the related art thin film type solar cell.
FIGS. 2A to 2G are schematic cross-sectional views illustrating a process of manufacturing a thin film type solar cell according to an embodiment of the present invention.
FIG. 3 is a schematic plan view of a thin film type solar cell according to an embodiment of the present invention.

### [Mode for Invention]

Advantages and features of the present invention, and implementation methods thereof will be clarified through following embodiments described with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art. Further, the present invention is only defined by scopes of claims.

A shape, a size, a ratio, an angle, and a number disclosed in the drawings for describing embodiments of the present invention are merely an example, and thus, the present invention is not limited to the illustrated details. Like reference numerals refer to like elements throughout. In the following description, when the detailed description of the relevant known function or configuration is determined to unnecessarily obscure the important point of the present invention, the detailed description will be omitted. In a case where 'comprise', 'have', and 'include' described in the present specification are used, another part may be added unless 'only∼' is used. The terms of a singular form may include plural forms unless referred to the contrary.

In construing an element, the element is construed as including an error range although there is no explicit description.

In describing a position relationship, for example, when a position relation between two parts is described as 'on∼', 'over∼', 'under∼', and 'next∼', one or more other parts may be disposed between the two parts unless 'just' or 'direct' is used.

In describing a time relationship, for example, when the temporal order is described as 'after∼', 'subsequent∼', 'next∼', and 'before∼', a case which is not continuous may be included unless 'just' or 'direct' is used.

It will be understood that, although the terms "first", "second", etc. may be used herein to describe various elements, these elements should not be limited by these terms. These terms are only used to distinguish one element from another. For example, a first element could be termed a second element, and, similarly, a second element could be termed a first element, without departing from the scope of the present invention.

Features of various embodiments of the present invention may be partially or overall coupled to or combined with each other, and may be variously inter-operated with each other and driven technically as those skilled in the art can sufficiently understand. The embodiments of the present invention may be carried out independently from each other, or may be carried out together in co-dependent relationship.

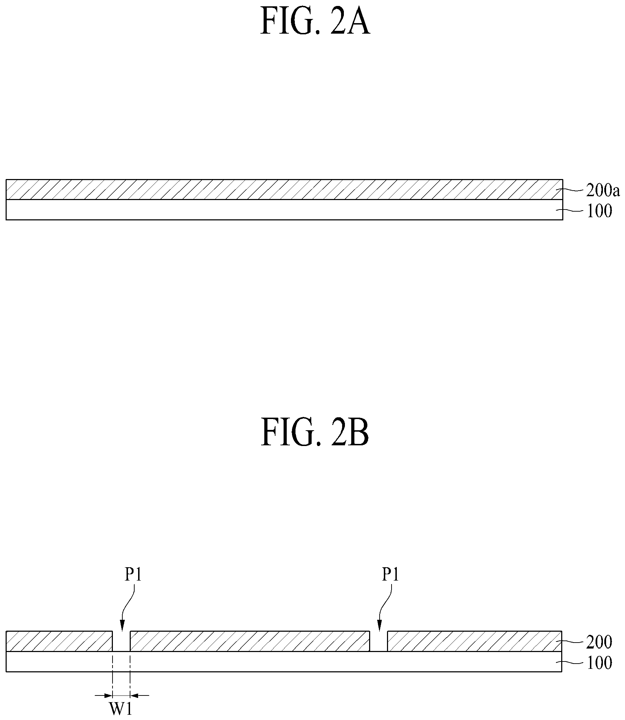

FIGS. 2A to 2G are schematic cross-sectional views illustrating a process of manufacturing a thin film type solar cell according to an embodiment of the present invention.

First, as seen in FIG. 2A, a first transparent electrode layer 200a is formed of a transparent conductive material on a substrate 100.

Glass or transparent plastic may be used as the substrate 100.

The first transparent electrode layer 200a may be formed of a transparent conductive material, such as ZnO, ZnO:B, ZnO:Al, SnO₂, SnO₂:F, indium tin oxide (ITO), or the like, by using a sputtering process, a metal organic chemical vapor deposition (MOCVD) process, or the like.

The first transparent electrode layer 200a may act as a front electrode layer on which sunlight is incident, and in this case, in order for the incident sunlight to be maximally absorbed into the solar cell, a texturing process of forming a concave-convex structure on a surface of the first transparent electrode layer 200a may be additionally performed.

Subsequently, as seen in FIG. 2B, a first separation part P1 having a first width W1 is formed in the first transparent electrode layer 200a.

Since the first separation part P1 is formed, a pattern of a plurality of first transparent electrodes 200 which are spaced apart from each other with the first separation part P1 therebetween may be obtained. In an area where the first separation part P1 is formed, a certain region of the first transparent electrode layer 200a is removed, and thus, a top of the substrate 100 is exposed.

A process of forming the first separation part P1 may be a laser scribing process. In this case, a laser may have a first wavelength range, and in more detail, may use a laser having an infrared wavelength range. When the laser scribing process is performed by using the laser having the infrared wavelength range, a certain region of the first transparent electrode layer 200a onto which the laser is irradiated may be removed, and the first separation part P1 may be formed.

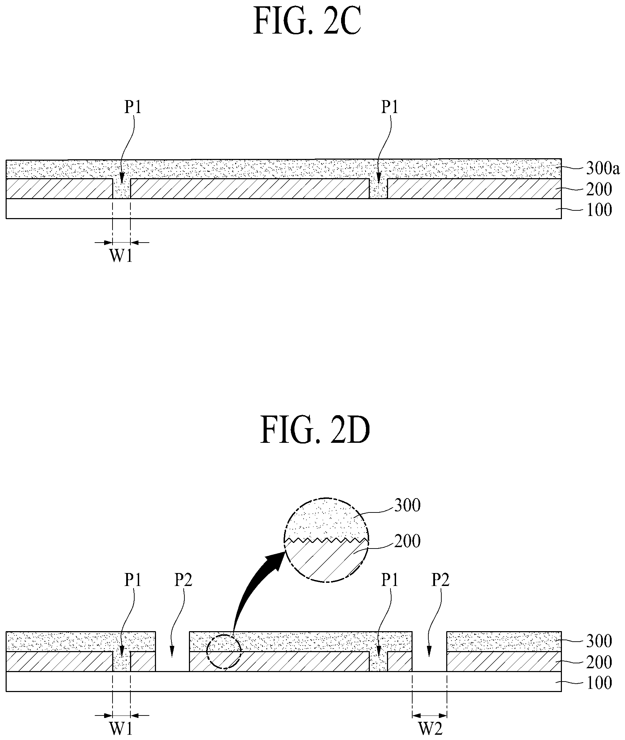

Subsequently, as seen in FIG. 2C, a semiconductor layer 300a is formed on the first transparent electrode 200.

The semiconductor layer 300a, as illustrated, is also formed in the first separation part P1 area.

The semiconductor layer 300a may be formed of a silicon-based semiconductor material by using a plasma chemical vapor deposition (PCVD) process, and the silicon-based semiconductor material may use amorphous silicon (a-Si:H) or microcrystalline silicon (µc-Si:H).

The semiconductor layer 300a may be formed in a PIN structure where a positive (P)-type semiconductor layer, an intrinsic (I)-type semiconductor layer, and a negative (N)-type semiconductor layer are sequentially stacked. If the semiconductor layer 300a is formed in the PIN structure, the I-type semiconductor layer is depleted by the P-type semiconductor and the N-type semiconductor layer, and thus, an electric field is generated therein, whereby holes and electrons generated by sunlight are drifted by the electric field. Therefore, the holes and the electrons are respectively collected in the P-type semiconductor layer and the N-type semiconductor layer.

The P-type semiconductor layer may be formed by doping a P-type dopant on amorphous silicon, the I-type semiconductor layer may be formed of amorphous silicon, and the N-type semiconductor layer may be formed by doping an N-type dopant on amorphous silicon. However, the present embodiment is not limited thereto.

In a case where the semiconductor layer 300a is formed in the PIN structure, it is preferable that the P-type semiconductor layer is formed at a position close to a portion on which sunlight is incident, and then, the I-type semiconductor layer and the N-type semiconductor layer are formed. The reason is for forming the P-type semiconductor layer at a position close to a light receiving surface in order to maximize carrier collection efficiency based on incident light because a drift mobility of holes is lower than that of electrons.

Subsequently, as seen in FIG. 2D, a contact part P2 having a second width W2 is formed in the semiconductor layer 300a. Therefore, a plurality of semiconductor layers 300 which are spaced apart from each other with the contact part P2 therebetween are obtained.

The contact part P2 is for electrically connecting the first transparent electrode 200 to a below-described second transparent electrode 400. Also, the contact part P2 acts as a light transmission area for see-through. That is, according to an embodiment of the present invention, since the contact part P2 may act as the light transmission area, it is not required to form the light transmission area through separate laser scribing unlike the related art, and thus, a process can be simplified, and the manufacturing cost can be reduced.

In this manner, the contact part P2 is formed to have the second width W2 which is relatively wide, in order to act as the light transmission area. Accordingly, the second width W2 of the contact part P2 is set wider than the first width W1 of the first separation part P1.

In an area where the contact part P2 is formed, a certain region of each of the first transparent electrode 200 and the semiconductor layer 300a is removed, and thus, the top of the substrate 100 is exposed. Accordingly, even when a surface of the first transparent electrode 200 is formed in a concave-convex structure, the first transparent electrode 200 is not formed in the contact part P2 area, and thus, visibility of the contact part P2 can be enhanced.

A process of forming the contact part P2 may be a laser scribing process. In this case, a laser may have the first wavelength range, and in more detail, may use a laser having an infrared wavelength range. When the laser scribing process is performed by using the laser having the infrared wavelength range, a certain region of the first transparent electrode 200 onto which the laser is irradiated may be removed, and simultaneously, a certain region of the semiconductor layer 300a formed thereon may be removed.

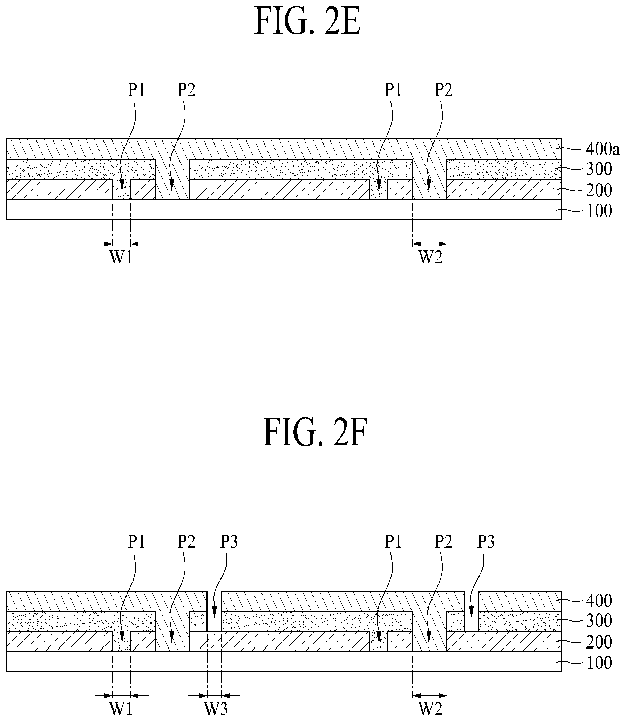

Subsequently, as seen in FIG. 2E, a second transparent electrode layer 400a is formed on the semiconductor layer 300.

The second transparent electrode layer 400a may be formed of a transparent conductive material, such as ZnO, ZnO:B, ZnO:Al, SnO₂, SnO₂:F, ITO, or the like, by using a sputtering process, a metal organic chemical vapor deposition (MOCVD) process, or the like. Also, the second transparent electrode layer 400a may be formed of a transparent conductive material, such as Ag, Al, Ag+Mo, Ag+Ni, Ag+Cu, and/or the like, by using the sputtering process or the like.

The second transparent electrode layer 400a is also formed in the contact part P2. Therefore, the second transparent electrode layer 400a contacts a side surface of the first transparent electrode 200 and the top of the substrate 100, in the contact part P2.

Subsequently, as seen in FIG. 2F, a second separation part P3 having a third width W3 is formed in the second transparent electrode layer 400a. Therefore, a plurality of second transparent electrodes 400 which are connected to the first transparent electrode 200 through the contact part P2 and are spaced apart from each other with the second separation part P3 therebetween are obtained.

In an area where the second separation part P3 is formed, a certain region of each of the semiconductor layer 300 and the second transparent electrode layer 400a is removed, and thus, a top of the first transparent electrode 200 is exposed.

The third width W3 of the second separation part P3 is set narrower than the second width W2 of the contact part P2.

A process of forming the second separation part P3 may be a laser scribing process. In this case, a laser may have a second wavelength range shorter than the first wavelength range, and in more detail, may use a laser having a green wavelength range. When the laser scribing process is performed by using the laser having the green wavelength range, a certain region of the semiconductor layer 300 onto which the laser is irradiated may be removed, and simultaneously, a certain region of the second transparent electrode layer 400a formed thereon may be removed.

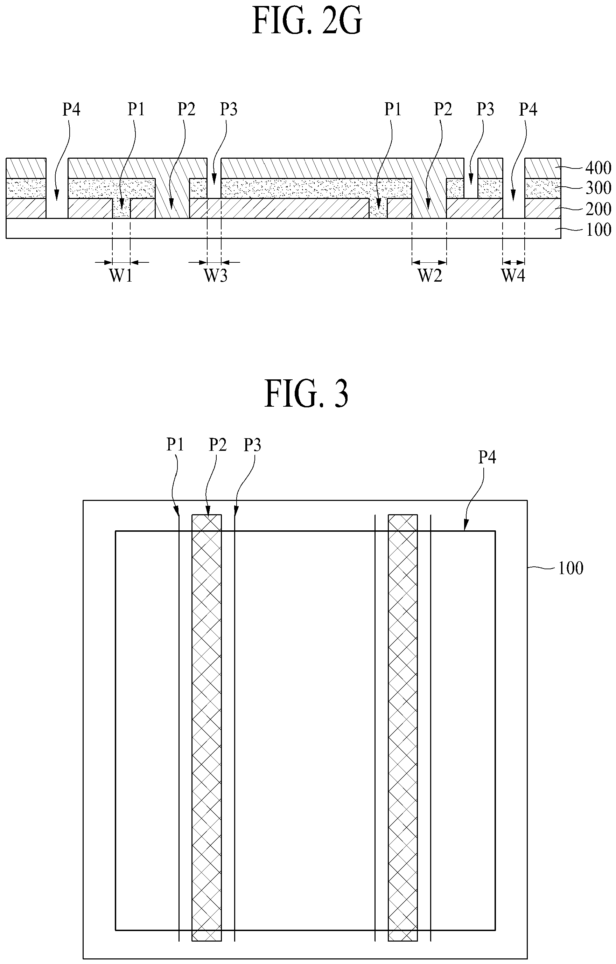

Subsequently, as seen in FIG. 2G, the third separation part P4 having a fourth width W4 is formed in the outer portion of the substrate 10. The outermost area of the substrate 10 is insulated by the third separation part P4.

In this manner, the outermost area of the substrate 10 is insulated through the third separation part P4, and thus, when connecting a housing to a thin-film solar cell for modularizing the thin-film solar cell, short circuit can be prevented from occurring between the housing and the thin-film solar cell.

The fourth width W4 of the third separation part P4 is set narrower than the second width W2 of the contact part P2.

In an area where the third separation part P4 is formed, a certain region of each of the first transparent electrode 200, the semiconductor layer 300, and the second transparent electrode layer 400a is removed, and thus, the top of the substrate 100 is exposed.

A process of forming the third separation part P4 may be a laser scribing process. In this case, a first laser having the first wavelength range (in more detail, an infrared wavelength range) may be primarily irradiated, and then, a second laser having the second wavelength range (in more detail, a green wavelength range) may be secondarily irradiated. Due to the first laser irradiation, a certain region of each of the first electrode 200, the semiconductor layer 300, and the second transparent electrode layer 400a may be removed, and due to the second laser irradiation, residual materials remaining in the third separation part P4 may be removed. If a residual material connecting the first transparent electrode 200 to the second transparent electrode 400 remains in the third separation part P4, short circuit occurs between the first transparent electrode 200 and the second transparent electrode 400, and thus, the second laser irradiation is performed for preventing short circuit.

As described above, according to an embodiment of the present invention, since the contact part P2 can act as a light transmission area, unlike the related art, it is not required to form the light transmission area through separate laser scribing. Accordingly, only a total four-time laser scribing process is needed for forming the first separation part P1, the contact part P2, the second separation part P3, and the third separation part P4, and thus, in comparison with the related art, a one-time laser scribing process is reduced, thereby decreasing the manufacturing cost.

Moreover, in the related art, since the surface of the first electrode 20 is formed in a concave-convex structure as in FIG. 1A, visibility of the light transmission part P5 is reduced. However, according to an embodiment of the present invention, despite the surface of the first electrode 200 being formed in the concave-convex structure, since the first electrode 200 is not formed in the contact part P2 area, visibility of the contact part P2 can be enhanced.

The thin film type solar cell according to an embodiment of the present invention manufactured by the process, as seen in FIG. 2G, includes the substrate 100, the first transparent electrode 200, the semiconductor layer 300, and the second transparent electrode 400.

The first transparent electrode 200 is provided on the substrate 100. The first transparent electrode 200 includes the first separation part P1 and the contact part P2.

The semiconductor layer 300 is provided in the first separation part P1 and on the first transparent electrode 200.

The contact part P2 is provided to pass through the first transparent electrode 200 and the semiconductor layer 300.

The second transparent electrode 400 is provided on the semiconductor layer 300. The second transparent electrode 400 is formed in the contact part P2 and is connected to the first transparent electrode 200. The second transparent electrode 400 is provided in plurality, and the plurality of second transparent electrodes 400 are spaced apart from each other with the second separation part P3 therebetween.

The second separation part P3 is provided to pass through the semiconductor layer 300 and the second transparent electrode 400.

The second transparent electrode 400 contacts the substrate 100 through the semiconductor layer 300 and the first transparent electrode 200. In detail, the second transparent electrode 400 contacts the first transparent electrode 200 in the contact part P2, and moreover, contacts the substrate 100. Particularly, the second transparent electrode 400 contacts a side surface of the first transparent electrode 200 in the contact part P2, and moreover, contacts the top of the substrate 100.

Here, the second width W2 of the contact part P2 is set wider than the first width W1 of the first separation part P1, the third width W3 of the second separation part P3, and the fourth width W4 of the third separation part P4.

The third separation part P4 is formed in the outer portion of the substrate 10. The third separation part P4 is provided by removing a certain region of each of the first transparent electrode 200, the semiconductor layer 300, and the second transparent electrode 400.

According to an embodiment of the present invention, a size of a grain of the second transparent electrode 400 is smaller than that of a grain of the first transparent electrode 200. Therefore, the second transparent electrode 400 is higher in light transmittance than the first transparent electrode 200, and thus, a light transmittance of the contact part P2 can be enhanced.

Moreover, a reflectivity of the first transparent electrode 200 is higher than that of the second transparent electrode 400. That is, since a size of the grain of the first transparent electrode 200 is larger than that of the grain of the second transparent electrode 400, a reflectivity of the first transparent electrode 200 is higher than that of the second transparent electrode 400, and thus, a light path can be expanded in the solar cell, thereby enhancing cell efficiency.

In this manner, a concentration of oxygen contained in the second transparent electrode 400 which is relatively small in grain size is higher than a concentration of oxygen contained in the first transparent electrode 200 which is relatively large in grain size. That is, it is preferable to increase an oxygen concentration of a transparent conductive material, for decreasing a grain size.

According to an embodiment of the present invention, a portion of each of the first transparent electrode 200 and the second transparent electrode 400 contacting the top of the substrate 100 may act as a front electrode, and a portion of the second transparent electrode 400 contacting a top of the semiconductor layer 300 may act as a rear electrode.

That is, the front electrode includes a first area (i.e., a portion of the first transparent electrode 200), having a first grain size which is relatively large, and a second area (i.e., a portion of the second transparent electrode 400 formed in the contact part P2) having a second grain size which is relatively small.

Therefore, the second area (i.e., the portion of the second transparent electrode 400 formed in the contact part P2) is formed of a transparent conductive material which is the same as that of the rear electrode, namely, a portion of the second transparent electrode 400 contacting the top of the semiconductor layer 300. Also, the second area and the rear electrode are formed as one body and are connected to each other.

FIG. 3 is a schematic plan view of the thin film type solar cell according to an embodiment of the present invention.

As seen in FIG. 3, the first separation part P1, the contact part P2, and the second separation part P3 are repeatedly arranged on the substrate 100 in a certain direction, for example, a vertical direction. The plurality of unit cells may be divided by a repetition unit by which the first separation part P1, the contact part P2, and the second separation part P3 are repeated. In this case, the width of the contact part P2 is larger than that of each of the first separation part P1, the second separation part P3, and the third separation part P4. Accordingly, a light transmission area is secured by the contact part P2, and thus, a see-through type may be implemented.

The third separation part P4 is formed in the outer portion of the substrate 100. The third separation part P4 electrically insulates the outermost area of the substrate 100 from a plurality of unit cells disposed inward therefrom. The third separation part P4 is provided in a shape corresponding to a shape of the substrate 10. That is, the third separation part P4 extends along a shape of an end of the substrate 100 by a certain distance in the end of the substrate 100. Accordingly, as illustrated, if the substrate 100 has a tetragonal structure, the third separation part P4 may be formed in a tetragonal frame structure smaller in size than the substrate 100.

The present invention as described above are not limited to the above-described embodiments and the accompanying drawings and those skilled in the art will clearly appreciate that various modifications, deformations, and substitutions are possible without departing from the scope and spirit of the invention. Therefore, it should be construed that the scope of the present invention is defined by the below-described claims instead of the detailed description, and the meanings and scope of the claims and all variations or modified forms inferred from their equivalent concepts are included in the scope of the present invention. Therefore, the scope of the invention is defined not by the detailed description of the invention but by the appended claims, and all differences within the scope will be construed as being included in the present invention.

## Claims

1. A thin film type solar cell comprising:
a substrate;
a first transparent electrode provided on the substrate, the first transparent electrode having a first separation part;
a semiconductor layer formed in the first separation part and on the first transparent electrode;
a contact part formed to pass through the first transparent electrode and the semiconductor layer;
a second transparent electrode formed in the contact part and on the semiconductor layer; and
a second separation part formed to pass through the semiconductor layer and the second transparent electrode,
wherein a size of a grain of the contact part is smaller than a size of a grain of the first transparent electrode.

2. A thin film type solar cell comprising a first transparent electrode, a semiconductor layer, and a second transparent electrode sequentially formed on a substrate, wherein the second transparent electrode contacts the substrate by passing through the semiconductor layer and the first transparent electrode, and a size of a grain of the second transparent electrode is smaller than a size of a grain of the first transparent electrode.

3. A thin film type solar cell comprising a first transparent electrode, a semiconductor layer, and a second transparent electrode sequentially formed on a substrate, wherein the second transparent electrode contacts the substrate by passing through the semiconductor layer and the first transparent electrode, and a reflectivity of the first transparent electrode is higher than a reflectivity of the second transparent electrode.

4. A thin film type solar cell comprising a first transparent electrode, a semiconductor layer, and a second transparent electrode sequentially formed on a substrate, wherein the second transparent electrode contacts the substrate by passing through the semiconductor layer and the first transparent electrode, and an oxygen concentration of the second transparent electrode is higher than an oxygen concentration of the first transparent electrode.

5. The thin film type solar cell of one of claims 1 to 4, wherein the second transparent electrode contacts a side surface of the first transparent electrode.

6. The thin film type solar cell of claim 1, wherein the second transparent electrode contacts a top of the substrate, in the contact part.

7. The thin film type solar cell of claim 1, wherein a width of the contact part is wider than a width of the first separation part and a width of the second separation part.

8. A thin film type solar cell comprising a front electrode, a semiconductor layer, and a rear electrode that are formed on a substrate, wherein the front electrode includes a first area having a first grain size and a second area having a second grain size smaller than the first grain size, and the second area is connected to the rear electrode.

9. The thin film type solar cell of claim 8, wherein the second area and the rear electrode are formed of the same transparent conductive material and are formed as one body.

10. A method of manufacturing a thin film type solar cell, the method comprising:
a process of forming a first transparent electrode layer on a substrate;
a process of removing a certain region of the first transparent electrode layer to form a first separation part, thereby forming a plurality of first transparent electrodes which are spaced apart from each other with the first separation part therebetween;
a process of forming a semiconductor layer on the plurality of first transparent electrode;
a process of removing a certain region of the semiconductor layer and the plurality of first transparent electrode to form a contact part, thereby forming a plurality of semiconductor patterns which are spaced apart from each other with the contact part therebetween;
a process of forming a second transparent electrode layer on the plurality of semiconductor patterns; and
a process of removing a certain region of each of the plurality of semiconductor patterns and the second transparent electrode layer to form a second separation part, thereby forming a plurality of second transparent electrodes which are connected to the plurality of first transparent electrode through the contact part and are spaced apart from each other with the second separation part therebetween.

11. The thin film type solar cell of claim 10, wherein the plurality of second transparent electrode contacts a side surface of the plurality of first transparent electrode and a top of the substrate, in the contact part.

12. The thin film type solar cell of claim 10, wherein a width of the contact part is wider than a width of the first separation part and a width of the second separation part.
